# EUROPÄISCHE PATENTSCHRIFT

(11) **EP 0 413 054 B1**
(45) Veröffentlichungstag und Bekanntmachung des Hinweises auf die Patenterteilung: **26.10.1994**
(21) Anmeldenummer: 89115285.2
(22) Anmeldetag: 18.08.1989
(51) Int. Cl.: H01L 27/02

(54) **Eingangsschutzstruktur für integrierte Schaltungen**
Input protection structure for integrated circuits
Structure de protection d'entrée pour circuits intégrés

(43) Veröffentlichungstag der Anmeldung: 20.02.1991
(73) Patentinhaber: SIEMENS AKTIENGESELLSCHAFT, 80333 München (DE)
(72) Erfinder: Becker, Burkhard, Dr., D-8000 München 80 (DE)

(56) Entgegenhaltungen:
- GB-A- 2 176 053
- US-A- 4 017 882
- US-A- 4 486 770
- PATENT ABSTRACTS OF JAPAN vol. 5, no. 145 (E-74)(817) 12 September 1981 ; & JP-A-56 79 463
- PATENT ABSTRACTS OF JAPAN vol. 12, no. 239 (E-630)(3086) 07 Juli 1988 ; & JP-A-63 31 153

## Beschreibung

Die vorliegende Erfindung betrifft eine Eingangsschutzstruktur gegen elektrostatische Entladungen mit den Merkmalen:
(a) die Eingangsschutzstruktur enthält in einem Halbleitersubstrat mindestens einen bipolaren Transistor und einen integrierten Widerstand,
(b) der Kollektor des Transistors ist mit einem Eingang der integrierten Schaltung verbunden,
(c) die Basis des Transistors ist über den Widerstand mit dem Emitter des Transistors verbunden und an ein Referenzpotential angeschlossen,
(d) ein Bereich eines ersten Leitfähigkeitstyps des Halbleitersubstrats bildet den Kollektor,
(e) eine im Bereich angeordnete erste Zone eines zweiten Leitfähigkeitstyps enthält die Basis und den integrierten Widerstand,
(f) eine in der ersten Zone angeordnete zweite Zone des ersten Leitfähgigkeitstyps bildet den Emitter,
(g) eine zwischen dem Emitter und einem Basisanschluß liegende Teilzone der ersten Zone bildet den integrierten Widerstand.

Eine solche Eingangsschutzstruktur ist in der Offenlegungsschrift GB 2 176 053 gezeigt. Die Realisierung der Schutzstruktur im Halbleitersubstrat sieht vor, den Bipolartransistor in einer epitaktischen Schicht an der Oberfläche des Halbleitersubstrats anzuordnen, wobei der Kollektor dieses Transistors in üblicher Weise durch die hochohmige epitaktische Schicht und Basis sowie Emitter durch zwei entsprechende Diffusionsgebiete in der epitaktischen Schicht gebildet sind. Bei dieser Ausgestaltung des Transistors können aufgrund der erhöhten Ladungsträgerdichte in der Nähe der Systemoberfläche sowie der Krümmung des Emitter-Basis-Übergangs Oberflächenfrühdurchbrüche auftreten, wodurch eine frühzeitige Zerstörung des Bauelements bedingt wird.

In der US-Patentschrift US 4 017 882 ist ein diskreter Transistor mit einer integrierten Schutzschaltung gezeigt. Die Kollektorzone reicht zentral von der Unterseite des Halbleiterkörpers bis zur Oberseite und wird von einer ringförmigen Basiszone umgeben. In die Basiszone ist ein Ringemitter eingebettet. Außerhalb des ringförmigen Basiskontakts ist ein erster Schutzbereich als Hilfsemitter angeordnet, zentrisch innerhalb des zentralen Kollektorbereichs ist ein weiterer Schutzbereich angeordnet. Für einen wirksamen Schutz sind also mindestens zwei Schutzbereiche vorgesehen, so daß insgesamt der Flächenbedarf des Transistors relativ groß ist.

In der Veröffentlichung Patent Abstracts of Japan 12 (239), (E-630) <3086> ist eine Eingangsschutzstruktur mit einem Bipolartransistor und einem Widerstand gezeigt. Die Kollektor-Emitter-Strecke ist zwischen den Eingangsanschluß der integrierten Schaltung und ein Referenzpotential geschaltet, der Widerstand liegt zwischen Basis und Emitter des Bipolartransistors. Der Transistor ist an der Oberfläche eines Halbleitersubstrats realisiert, so daß die Gefahr von Oberflächenfrühdurchbrüchen besteht.

Der vorliegenden Erfindung liegt daher die Aufgabe zugrunde, eine flächensparende Eingangsschutzstruktur der in Rede stehenden Art anzugeben, die eine hohe Belastbarkeit, insbesondere aufgrund einer Homogenisierung des Feldverlaufs sowie einer Entlastung von oberflächennahen Bereichen, aufweist.

Diese Aufgabe wird bei einer Eingangsschutzstruktur der eingangs genannten Art dadurch gelöst, daß
(h) der Transistor einen weiteren Emitter aufweist, der nur an die Basis angeschlossen ist,
(i) eine in der ersten Zone angeordnete dritte Zone des ersten Leitfähigkeitstyps den weiteren Emitter bildet,
(j) der weitere Emitter den Emitter umschließt und
(k) die unterhalb des weiteren Emitters angeordnete Zone einen Teil des integrierten Widerstandes bildet.

Weiterbildungen der Erfindung sind Gegenstand von Unteransprüchen.

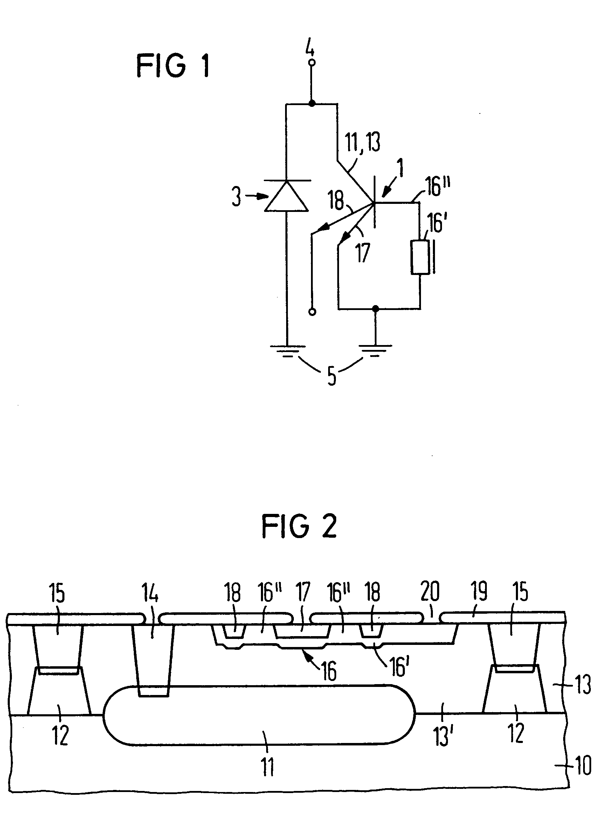

Die Erfindung wird im folgenden anhand eines Ausführungsbeispiels gemäß den FIG 1 und 2 der Zeichnung näher erläutert. Es zeigt:
- FIG 1: ein Ersatzschaltbild einer Eingangsschutzstruktur in Form einer Diode und eines Transistors gemäß der Erfindung, womit ein Schutz gegen elektrostatische Entladungen beider Polaritäten möglich ist; und
- FIG 2: eine schematische Darstellung der Realisierung einer Eingangsschutzstruktur nach FIG 1 in einem Halbleitersystem.

Gemäß FIG 1 liegt zwischen einem Eingangsanschluß 4 einer integrierten Schaltung, insbesondere einer bipolaren integrierten Schaltung, und einem Referenzpotential 5, insbesondere Masse, eine Schutzstruktur, welche durch einen Transistor 1 mit der oben bereits erläuterten Kopplung zwischen Basis 16˝ und Emitter 17 über einen Widerstand 16′ sowie einen Kollektor 11, 13′ und eine Diode 3 gebildet ist. Insbesondere ist dabei der Kollektor 11, 13′ des Transistors 1 an den Eingangsanschluß 4 und der Verbindungspunkt zwischen Emitter 17 und Widerstand 16′ an das Bezugspotential 5 angeschlossen. Der Transistor 1 weist einen weiteren zweiten Emitter 18 auf, der nur an die Basis 16˝ angeschlossen ist. Aufgrund der sich aus FIG 1 ergebenden Schaltungspolaritäten des Transistors 1 und der Diode 3 wirkt diese Schutzstruktur für elektrostatische Entladungen beider Polaritäten.

Die Bezugszeichen nach FIG 1, insbesondere für den Transistor 1 und dessen Beschaltung durch den Widerstand 16′ sind in Übereinstimmung mit den Bezugszeichen nach FIG 2 des im folgenden zu erläuternden Halbleitersystems gewählt, in dem die Schutzstruktur realisiert ist. Die Schutzstruktur im Halbleitersystem nach FIG 2 wird im folgenden anhand der schematischen Verfahrensabfolge bei der Herstellung erläutert.

Ausgangspunkt für die Herstellung des Halbleitersystems nach FIG 2 ist ein Halbleitersubstrat 10 eines Leitungstyps, bei dem es sich vorzugsweise um den p-Leitungstyp handelt. In dieses Halbleitersystem wird in an sich konventioneller Weise zunächst eine insbesondere hochdotierte Zone des entgegengesetzten Leitungstyps, im vorliegenden Beispiel also des n-Leitungstyps, eindiffundiert, durch die mit den nachfolgenden Herstellungsschritten eine buried layer-Zone 11 gebildet wird. Weiterhin werden in das Halbleitersubstrat Zonen mit dem Leitungstyp des Halbleitersubstrats eindiffundiert, welche ebenfalls in Verbindung mit den nachfolgenden Herstellungsschritten Teilzonen 12 eines an sich üblichen Isolationsrahmens bilden.

Anschließend wird in bekannter Weise auf das insoweit behandelte Halbleitersubstrat 10 eine epitaktische Schicht 13 mit gegenüber dem Halbleitersubstrat 10 entgegengesetzten Leitungstyp, im vorliegenden Beispiel also mit n-Leitungstyp, aufgebracht. Die buried-layer-Zone 11, die in Verbindung mit einem Teilbereich 13′ der epitaktischen Schicht 13 den Kollektor eines Transistors entsprechend dem Transistor 1 nach FIG 1 bildet, wird durch eine hochdotierte Anschlußzone 14 mit dem Leitungstyp der buried-layer-Zone 11 angeschlossen, welche vorteilhafterweise, aber nicht zwingend erforderlich, durch die epitaktische Schicht hindurch bis in die buried-layer-Zone 11 hineinreichend eindiffundiert wird.

Nachfolgend werden in weiteren Diffusionsschritten Zonen 15 und 16 mit dem Leitungstyp des Halbleitersubstrats 10, im vorliegenden Ausführungsbeispiel also mit p-Leitungstyp, in den Teilbereich 13′ der epitaktischen Schicht 13 eingebracht. Dabei vervollständigen die in die Teilzonen 12 hineinreichenden Zonen 15 den an sich konventionellen Isolationsring für den gesamten die Zonenfolge 11 bis 16 enthaltenden Bereich des Halbleitersystems.

Anschließend werden in die Zone 16 Zonen 17 und 18 vom Leitungstyp der epitaktischen Schicht 13, im vorliegenden Ausführungsbeispiel also vom n-Leitungstyp, eindiffundiert. Die Zone 18 umschließt dabei die Zone 17, beide Zonen sind durch einen Teil der Zone 16 voneinander isoliert.

Schließlich wird auf die Oberfläche des Halbleitersystems eine isolierende Schicht 19 aufgebracht und derart strukturiert, daß die Zonen 14, 16 und 17 anschließbar sind. Der Anschluß 20 der Zone 16 ist dabei auf der dem Kollektoranschluß 14 abgewandten Seite vorgesehen.

Aufgrund der vorstehend erläuterten Zonenstruktur ergibt sich im Halbleitersystem ein Transistor entsprechend dem Transistor 1 nach FIG 1, dessen Kollektor durch die buried layer-Zone 11 und einen Teilbereich 13′ der epitaktischen Schicht 13 mit dem Kollektoranschluß 14, dessen Basis durch eine Teilzone 16˝ der Zone 16, welche innerhalb der Zone 18 liegt, und dessen Emitter durch die Zone 17 gebildet wird. Der zweite, nur an die Basis angeschlossene Emitter 18 wird durch die Zone 18 gebildet, die nur mit der Teilzone 16˝ und der isolierenden Schicht 19 in Kontakt steht. Der die Basis 16˝ und den Emitter 17 koppelnde Widerstand 16′ gemäß FIG 1 wird im System nach FIG 2 durch eine Teilzone 16′ der Zone 16 gebildet, die zwischen Zone 17 und Anschluß 20 liegt (insbesondere unterhalb der Zone 18). Die Größe des Widerstandes 16′ wird vor allem durch die Dimensionierung der Diffusionszone 18 eingestellt (Pinch-Widerstand). Die Dimensionierung der Diffusionszonen 16 und 17 sowie die Lage des Anschlusses 20 sind ebenfalls von (i.a. sekundärer) Bedeutung. Durch die Öffnungen in der isolierenden Schicht 19 werden (über eine in FIG 2 nicht dargestellte Leiterbahn) die Emitterdiffusionszone 17 und der von der Basis abgewandte Anschluß 20 des Widerstandes 16′ gemäß FIG 1 gemeinsam an das Bezugspotential angeschlossen.

In Weiterbildung der Erfindung wird über die Kollektoranschlußzone 14 und den pn-Übergang zwischen der buried layer-Zone 11 und dem Halbleitersubstrat 10 eine Diode gebildet, welche der Diode 3 nach FIG 1 entspricht.

Der sogenannte Emitter-Feld-Ring 18 beeinflußt in Verbindung mit dem Anschluß 20 der Basis 16˝ über den integrierten Widerstand 16′ auf der dem Kollektoranschluß 14 abgewandten Seite die Schutzwirkung der Schaltung besonders vorteilhaft. Es wird eine Homogenisierung des Feldstärke- und Stromverlaufs erreicht; insbesondere wird der dem Kollektoranschluß 14 gegenüberliegende empfindliche Seitenbereich des Basis-Emitter-Übergangs wesentlich entlastet, so daß Oberflächenfrühdurchbrüche ausgeschlossen, sowie Lawinendurchbrüche an der Stelle des kleinsten Krümmungsradius bei negativen Eingangsimpulsen weitgehend verzögert werden. Bei Prozesslinien mit einer fehlenden tiefreichenden buried-layer-Anschlußdiffusion 14 kommt dieser vorteil in besonderem Maße zum Tragen, da hier der Eingangsimpuls nicht aus dem oberflächennahen Bereich abgeführt werden kann und dementsprechend hier eine starke Belastung des Bauelements auftritt.

Negative Spannungsimpulse werden einerseits über die durch die buried layer-Zone 11 und das Halbleitersubstrat 10 gebildete Diode, aber auch über den Emitteranschluß nach Bezugspotential (Masse) abgeführt, da der Transistor der Schutzstruktur im inversen Betrieb arbeitet, wobei der Basis-Emitter-Übergang in Sperrichtung gepolt ist. Der Emitter-Feld-Ring 18 sowie der Basis-Anschluß 20 sorgen für eine Homogenisierung des Feldstärke- und Stromverlaufs.

Positive Spannungsimpulse schalten die Kollektor-Basis-Diode des Transistors 1 in Sperrichtung sowie die Basis-Emitter-Diode in Durchlaßrichtung. Über den kurzgeschlossenen Basisanschluß 20 kann ein Stromfluß aus der Basis 16˝ erfolgen, so daß die Schutzstruktur in die normale Transistorarbeitsweise übergeht. Durch die Erdung des Basisanschlusses 20 erfolgt das Durchschalten des Transistors in Form eines Durchbruchs über die Kollektor-Emitter-Strecke in Verbindung mit der Widerstandskopplung zwischen Basis und Emitter.

Die vorstehend erläuterte Schutzstruktur leitet Spannungsimpulse aufgrund ihrer kurzen Durchschaltzeit ab, bevor parallelliegende Funktionseinheiten in der zu schützenden integrierten Schaltung zerstört werden können. Die Polung des empfindlichen Basis-Emitter-Übergangs in Durchlaßrichtung garantiert zudem eine hohe Belastbarkeit der Schutzstruktur.

Der Vorteil der erfindungsgemäßen Schutzstruktur liegt insbesondere in ihrer Verwendungsmöglichkeit für hohe Signalspannungen der zu schützenden integrierten Schaltung.

## Patentansprüche

1. Eingangsschutzstruktur gegen elektrostatische Entladungen für integrierte Schaltungen mit den Merkmalen:
(a) die Eingangsschutzstruktur enthält in einem Halbleitersubstrat (10) mindestens einen bipolaren Transistor (1) und einen integrierten Widerstand (16′),
(b) der Kollektor (11, 13′) des Transistors (1) ist mit einem Eingang (4) der integrierten Schaltung verbunden,
(c) die Basis (16˝) des Transistors (1) ist über den Widerstand (16′) mit dem Emitter (17) des Transistors (1) verbunden und an ein Referenzpotential (5) angeschlossen,
(d) ein Bereich eines ersten Leitfähigkeitstyps des Halbleitersubstrats (10) bildet den Kollektor (11, 13′),
(e) eine im Bereich angeordnete erste Zone (16) eines zweiten Leitfähigkeitstyps enthält die Basis (16˝) und den integrierten Widerstand (16′),
(f) eine in der ersten Zone (16) angeordnete zweite Zone (17) des ersten Leitfähgigkeitstyps bildet den Emitter (17),
(g) eine zwischen dem Emitter (17) und einem Basisanschluß (20) liegende Teilzone (16′) der ersten Zone (16) bildet den integrierten Widerstand (16′),
**dadurch gekennzeichnet,** daß
(h) der Transistor (1) einen weiteren Emitter (18) aufweist, der nur an die Basis (16˝) angeschlossen ist,
(i) eine in der ersten Zone (16) angeordnete dritte Zone (18) des ersten Leitfähigkeitstyps den weiteren Emitter bildet,
(j) der weitere Emitter (18) den Emitter (17) umschließt und
(k) die unterhalb des weiteren Emitters (18) angeordnete Zone (16˝) einen Teil des integrierten Widerstandes (16′) bildet.

2. Eingangsstruktur nach Anspruch 1, **dadurch gekennzeichnet,** daß der den Kollektor (11, 13′) bildende Bereich ein vergrabenes hochdotiertes Gebiet (11) und einen Teilbereich (13′) einer epitaktischen Schicht (13) umfaßt.

3. Eingangsschutzstruktur nach Anspruch 1 oder 2, **dadurch gekennzeichnet,** daß der integrierte Widerstand (16′) durch die laterale und/oder vertikale Dimensionierung der ersten (16), zweiten (17) und/oder dritten Zone (18) und/oder durch die Positionierung des Basisanschlusses (20) eingestellt wird.

4. Eingangsschutzstruktur nach Anspruch 1 oder 2, **dadurch gekennzeichnet,** daß der Kollektor (11, 13′) und das Halbleitersubstrat (10) eine integrierte Schutzdiode (3) bilden.

## Claims

1. Input protection structure against electrostatic discharges for integrated circuits, having the features:
(a) the input protection structure contains at least one bipolar transistor (1) and one integrated resistor (16′) in a semiconductor substrate (10),
(b) the collector (11, 13′) of the transistor (1) is connected to one input (4) of the integrated circuit,
(c) the base (16˝) of the transistor (1) is connected to the emitter (17) of the transistor (1) via the resistor (16′) and is connected to a reference potential (5),
(d) an area of a first type of conductivity of the semiconductor substrate (10) forms the collector (11, 13′),
(e) a first zone (16) of a second type of conductivity, which is arranged in the area, contains the base (16˝) and the integrated resistor (16′),
(f) a second zone (17) of the first type of conductivity, arranged in the first zone (16), forms the emitter (17),
(g) a part-zone (16′) of the first zone (16), which is located between the emitter (17) and a base terminal (20), forms the integrated resistor (16′),
characterized in that
(h) the transistor (1) exhibits a further emitter (18) which is only connected to the base (16˝),
(i) a third zone (18) of the first type of conductivity, which is arranged in the first zone (16), forms the further emitter,
(j) the further emitter (18) encloses the emitter (17), and
(k) the zone (16˝) arranged underneath the further emitter (18) forms a part of the integrated resistor (16′).

2. Input structure according to Claim 1, characterized in that the area forming the collector (11, 13′) comprises a buried highly-doped region (11) and a part-area (13′) of an epitaxial layer (13).

3. Input protection structure according to Claim 1 or 2, characterized in that the integrated resistor (16′) is adjusted by the lateral and/or vertical dimensioning of the first (16), second (17) and/or third zone (18) and/or by the positioning of the base terminal (20).

4. Input protection structure according to Claim 1 or 2, characterized in that the collector (11, 13′) and the semiconductor substrate (10) form an integrated protection diode (3).

## Revendications

1. Structure de protection d'entrée vis-à-vis de décharges électrostatiques, pour des circuits intégrés, présentant les caractéristiques suivantes:
(a) la structure de protection d'entrée comporte, dans un substrat semiconducteur (10), au moins un transistor bipolaire (1) et une résistance intégrée (16′),
(b) le collecteur (11, 13′) du transistor (1) est relié à une entrée (4) du circuit intégré,
(c) la base (16˝) du transistor (1) est reliée, par l'intermédiaire de la résistance (16'), à l'émetteur (17) du transistor (1) et est placée à un potentiel de référence (5),
(d) une région possédant un premier type de conductivité du substrat semiconducteur (10) forme le collecteur (11, 13′),
(e) une première zone (16), disposée dans ladite région et possédant un second type de conductivité, contient la base (16˝) et la résistance intégrée (16′),
(f) une seconde zone (17), disposée dans la première zone (16) et possédant le premier type de conductivité, forment l'émetteur (17),
(g) une partie (16'), située entre l'émetteur (17) et une borne de base (20), de la première zone (16) forme la résistance intégrée (16′),
caractérisée par le fait que
(h) le transistor (1) possède un autre émetteur (18), qui est raccordé uniquement à la base (16˝),
(i) une troisième zone (18), qui est disposée dans la première zone (16) et possède le premier type de conductivité, forme l'autre émetteur,
(j) l'autre émetteur (18) entoure l'émetteur (17), et
(k) la zone (16˝), disposée au-dessous de l'autre émetteur (18), forme une partie de la résistance intégrée (16′).

2. Structure d'entrée suivant la revendication 1, caractérisée par le fait que la région, qui forme le collecteur (11, 13′), est une région ensevelie fortement dopée (11) et entoure une région partielle (13′) d'une couche épitaxiale (13).

3. Structure d'entrée suivant la revendication 1 ou 2, caractérisée par le fait que la résistance intégrée (16′) est réglée au moyen du dimensionnement latéral et/ou vertical de la première zone (16), de la seconde zone (17) et/ou de la troisième zone (18) et/ou au moyen du positionnement de la borne de base (20).

4. Structure d'entrée suivant la revendication 1 ou 2, caractérisée par le fait que le collecteur (11, 13′) et le substrat semiconducteur (10) forment une diode de protection intégrée (3).
